# EUROPÄISCHE PATENTSCHRIFT

(11) **EP 3 310 547 B1**
(45) Veröffentlichungstag und Bekanntmachung des Hinweises auf die Patenterteilung: **24.11.2021**
(21) Anmeldenummer: 16720369.4
(22) Anmeldetag: 18.04.2016
(51) Int. Cl.: B29C 45/16, B29C 45/00, B60R 16/023, H05K 5/00, H05K 7/20, H05K 5/06

(54) **KUNSTSTOFFGEHÄUSE UND VERFAHREN ZUR DESSEN HERSTELLUNG**
PLASTIC HOUSING AND METHOD FOR PRODUCING THE SAME
BOÎTIER EN MATIÈRE PLASTIQUE ET PROCÉDÉ POUR SA FABRICATION

(30) Priorität: 17.06.2015 DE 102015211100
(43) Veröffentlichungstag der Anmeldung: 25.04.2018
(73) Patentinhaber: Robert Bosch GmbH, 70442 Stuttgart (DE)
(72) Erfinder: GEISE, Stephan, 59602 Ruethen (DE); TÜCHERT, Carsten, 70199 Stuttgart (DE); APELT, Stefan, 71554 Weissach im Tal (DE)
(86) Internationale Anmeldenummer: PCT/EP2016/058567
(87) Internationale Veröffentlichungsnummer: WO 2016/202483

(56) Entgegenhaltungen:
- EP-A1- 1 701 431
- EP-A2- 0 531 656
- EP-A2- 0 792 095
- EP-A2- 1 762 432
- JP-A- H0 631 770
- JP-A- S56 104 264
- US-A1- 2005 068 750
- Michael Mahler: "Worldwide Plans for Harmonization of Automotive Radars", , 16. Mai 2011 (2011-05-16), Seite 56, XP055283637, Gefunden im Internet: URL:http://sites.nationalacademies.org/cs/ groups/bpasite/documents/webpage/bpa_06278 7.pdf [gefunden am 2016-06-24]
- Martina Lemmrich: "Kunststoffe: Wirtschaftliche Alternative zu Metall - Sechs Schritte zur Metall-Substitution", Industrie Anzeiger, 12. Januar 2010 (2010-01-12), Seiten 1-4, XP055283635, Gefunden im Internet: URL:http://www.industrieanzeiger.de/home/- /article/12503/27463145/Sechs+Schritte+zur +Metall-Substitution/art_co_INSTANCE_0000/ [gefunden am 2016-06-24] -& Martina Lemmrich: "Checkliste für die systematische Materialselektion", , 12. Januar 2010 (2010-01-12), Seite 1, XP055283636, Gefunden im Internet: URL:http://www.industrieanzeiger.de/c/docu ment_library/get_file?uuid=b07bba0d-867b-4 f7e-8b91-a8d856391019&groupId=12503 [gefunden am 2016-06-24]
- EGELKRAUT S ET AL: "Wärmeleitfähige Kunststoffe für Entwärmungsaufgaben", INTERNET CITATION, 15. Juli 2008 (2008-07-15), Seiten 1-12, XP007919365, Gefunden im Internet: URL:http://www.iisb.fraunhofer.de/de/arb_g eb/pub_les/KKK_peak_2008_Mz_ges.pdf
- Johannes Hörber: "Wärmeverteilung in elektronischen Baugruppen optimieren", Elektronik Praxis, 26. Oktober 2011 (2011-10-26), Seiten 1-2, XP055283321, Gefunden im Internet: URL:http://www.elektronikpraxis.vogel.de/w aermemanagement/articles/336531/ [gefunden am 2016-06-23]

## Beschreibung

Die Erfindung betrifft ein Kunststoffgehäuse, ein Verfahren zum Herstellen eines Kunststoffgehäuses mittels einer Spritzgießvorrichtung und eine Spritzgiessvorrichtung zum Herstellen eines Kunststoffgehäuses.

### Stand der Technik

Radarmodule werden zur Überwachung des Frontbereichs eines Kraftfahrzeuges beispielsweise hinter einem Firmensymbol des jeweiligen Herstellers in einem Kühlergrill platziert. Aktuelle Modulgehäuse werden in Serie im Aluminium-Druckgussverfahren hergestellt. Das Aluminiumgehäuse dient als Kühlkörper, um die entstehende Wärme des Sensors aus dem Platinenbereich zu führen.

In einem zweiten Bearbeitungsschritt werden die Übergangsflächen zu den thermoplastischen Abdeckkappen mechanisch zerspant, damit diese möglichst plan sind. Ebenso müssen z.B. Gewinde zur Fixierung der Platine im Gehäuse ins Aluminium geschnitten werden. Um das Eindringen von Feuchtigkeit zu verhindern, werden in einem dritten Schritt an die Außenflächen des Gehäuses Silikondichtungen eingesetzt. Diese können in einem separaten Prozess in einem speziellen Spritzgießwerkzeug gefertigt oder direkt in das in ein Spritzgießwerkzeug eingelegte Aluminiumgehäuse eingespritzt werden. Die Fertigungsschritte nehmen viel Zeit und Anlagentechnik in Anspruch und erhöhen somit den Bauteilpreis. Da die montierten Gehäuse später frei im Motorraum des Kraftfahrzeuges angebracht sind, kann die Aluminiumoberfläche durch aggressive Medien angegriffen werden und korrodieren. Durch eine solche Korrosionsschicht kann die Wärmeabfuhr behindert werden, der Sensor überhitzen und das Modul komplett ausfallen.

Die DE 697 29 344 T2 offenbart ein in einem Gehäuse angeordnetes Radarmodul für ein Kraftfahrzeug.

EP 1762432 A2 offenbart eine Heckleuchtenanordnung, insbesondere für Lastfahrzeuge, mit einem Leuchtengehäuse, welches eine transparente Lichtscheibe und ein Bodenteil enthält und einen Innenraum mit einer Lichtquellenanordnung mit Leuchtdioden umgibt, wobei das vollständig als ein Spritzgussteil aus einem gefüllten Kunststoff besteht, welcher ein spritzgussfähiges Kunststoff-Grundmaterial und Füllkörper enthält, welche die Wärmeleitfähigkeit erhöhen.

### Offenbarung der Erfindung

Die vorliegende Erfindung schafft ein Kunststoffgehäuse mit den Merkmalen des Patentanspruchs 1.

Die vorliegende Erfindung schafft des Weiteren ein Verfahren zum Herstellen eines Kunststoffgehäuses mittels einer Spritzgießvorrichtung Neue Beschreibungsseite 3 (Reinschrift) mit den Merkmalen des Patentanspruchs 8.

Eine Idee der vorliegenden Erfindung ist es, eine einfachere, schnellere und kostengünstigere Herstellung von wärmeleitfähigen Kunststoffgehäusen, insbesondere Radarmodulgehäusen, zu ermöglichen, die neben einer guten Medienbeständigkeit auch eine bestimmte Dichtigkeit gegen das Eindringen von Feuchtigkeit aufweisen. Ferner soll das Gehäuse durch eine günstigere Materialwahl ein geringeres Gewicht aufweisen und in möglichst wenigen Prozessschritten hergestellt werden können. Damit die Wärme ideal aus dem Platinenbereich abgeführt werden kann, müssen die partiellen Bereiche des Gehäuses eine hohe Planparallelität gegenüber der Platine aufweisen und Formtoleranzen auch bei erhöhten Temperaturen eingehalten werden.

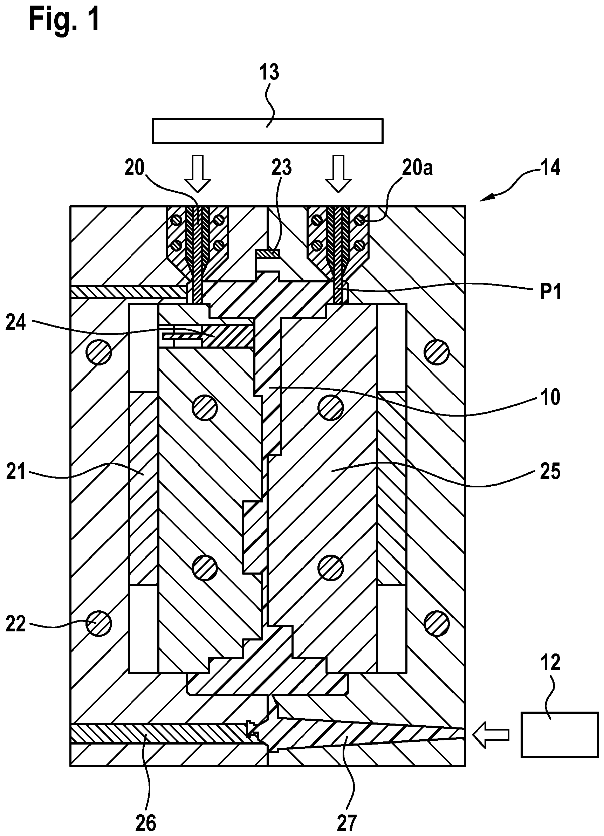

Die partiellen Bereiche sind die beispielsweise in Fig. 1 gezeigten, sichtbaren Bereiche eines ersten duroplastischen Kunststoffes zwischen jeweiligen Formeinsätzen eines Spritzgießwerkzeuges der Spritzgießvorrichtung. Somit kann ein kostengünstiges Kunststoffgehäuse, insbesondere Kunststoff-Radarmodulgehäuse hergestellt werden, das durch eine optimale Bauteilkonstruktion und gute Wärmeleitfähigkeit des duroplastischen Materials die entstehende Wärme des Sensors ideal aus dem Platinenbereich führt.

Nach dem Einspritzen des Gehäusematerials werden auf derselben Spritzgießmaschine im selben Spritzgießwerkzeug hydraulische Kerne gezogen, wodurch eine neue Kavität entsteht. In diese werden Dichtungen aus einem elastischen Kunststoff eingespritzt, die die Übergangsflächen zu Abdeckkappen des Gehäuses ohne zusätzlichen Montageaufwand stabil abdichten.

Da sich die duroplastischen Materialien chemisch vernetzen, entsteht ein mechanisch- und dimensionsstabiles Gehäuse, das auch bei hohen Temperaturen enge Formtoleranzen einhält. Die Flächen sind durch eine gute Oberflächenqualität sehr eben und müssen nicht mechanisch nachgearbeitet werden.

Die Verringerung der Prozessschritte im Vergleich zu Aluminiumgehäusen führt zu geringeren Kosten bei der Fertigungsanlagentechnik und zu einer enormen Fertigungszeitreduzierung, was den späteren Bauteilpreis verringert. Die duroplastischen Materialien sind sehr medienbeständig und haben durch die Fertigung in einem Spritzgießwerkzeug eine gute Haftung zueinander.

Durch die geringere Dichte des Kunststoffes im Vergleich zu Aluminium wird das Gehäuse leichter. Da die duroplastischen Materialien eine niedrigere Viskosität besitzen, können filigrane Gehäusebereiche oder Wanddickensprünge gut ausgeformt werden. Die niedrigere Viskosität des Duroplasts ermöglicht ebenfalls einen hohen Gehalt an wärmeleitfähigen Füllstoffen im Kunststoff, ohne das Fließverhalten deutlich zu verschlechtern. Somit wird eine sehr gute Wärmeleitfähigkeit des Materials mit einem guten Füllverhalten im Spritzgießwerkzeug erreicht.

Vorteilhafte Ausführungsformen und Weiterbildungen ergeben sich aus den Unteransprüchen sowie aus der Beschreibung unter Bezugnahme auf die Figuren.

Gemäß einer bevorzugten Weiterbildung ist vorgesehen, dass das Kunststoffgehäuse eine erste Abdeckkappe aufweist, welche an einem ersten Endabschnitt des Gehäusebauteils auf das Gehäusebauteil aufgesetzt ist, und eine zweite Abdeckkappe aufweist, welche an einem dem ersten Endabschnitt gegenüberliegenden zweiten Endabschnitt des Gehäusebauteils auf das Gehäusebauteil aufgesetzt ist. Durch das Vorsehen von zwei Abdeckkappen kann das Gehäusebauteil vorzugsweise von beiden Seiten aus mit beispielsweise elektronischen Komponenten bestückt werden. Damit ist eine effizientere Raumausnutzung des Gehäusebauteils möglich.

Gemäß einer weiteren bevorzugten Weiterbildung ist vorgesehen, dass das Gehäusebauteil an dem ersten Endabschnitt eine erste Übergangsfläche und an dem zweiten Endabschnitt eine zweite Übergangsfläche aufweist, wobei die erste Übergangsfläche und die zweite Übergangsfläche jeweils benachbart zu einem Randbereich des Gehäusebauteils stufenförmig ausgebildet sind. Die Übergangsfläche dient somit in vorteilhafter Weise als Auflagefläche zur Auflage des Dichtungselements.

Gemäß einer weiteren bevorzugten Weiterbildung ist vorgesehen, dass das Kunststoffgehäuse ein erstes Dichtungselement aufweist, welches an dem ersten Endabschnitt des Gehäusebauteils mit dem Gehäusebauteil stoffschlüssig verbunden und/oder an das Gehäusebauteil formschlüssig angespritzt ist, und ein zweites Dichtungselement aufweist, welches an dem zweiten Endabschnitt des Gehäusebauteils mit dem Gehäusebauteil stoffschlüssig verbunden und/oder an das Gehäusebauteil formschlüssig angespritzt ist. Durch Vorsehen des ersten Dichtungselements und des zweiten Dichtungselements können somit die erste Abdeckkappe und die zweite Abdeckkappe effektiv abgedichtet werden.

Gemäß einer weiteren bevorzugten Weiterbildung ist vorgesehen, dass das erste Dichtungselement in Richtung der ersten Abdeckkappe über den ersten Endabschnitt des Gehäusebauteils hervorsteht und das zweite Dichtungselement über den zweiten Endabschnitt in Richtung der zweiten Abdeckkappe des Gehäusebauteils hervorsteht. Somit kann das Gehäusebauteil zuverlässig mediendicht verschlossen werden.

Gemäß einer weiteren bevorzugten Weiterbildung ist vorgesehen, dass die zumindest eine Abdeckkappe das Gehäusebauteil im Bereich des Endabschnitts durch eine mit der Abdeckkappe integral ausgebildete Rastnase umgreift, welche mit einem im Bereich des Endabschnitts des Gehäusebauteils ausgebildeten Vorsprung im Eingriff ist. Somit können die Abdeckkappen einfach und sicher am Gehäusebauteil befestigt werden.

Gemäß einer weiteren bevorzugten Weiterbildung ist vorgesehen, dass der erste, duroplastische Kunststoff aus einem Epoxidharz, einer Phenolformmasse oder einem BMC ausgebildet ist, wobei der erste, duroplastische Kunststoff mit 30-90%, vorzugsweise 50-70% wärmeleitfähigen Feststoffpartikeln gefüllt ist, und wobei die wärmeleitfähigen Feststoffpartikel aus Bornitrid, Aluminium- und/oder Magnesiumhydroxid ausgebildet sind. Vorstehend genannte Stoffe und Verbindungen sind zur Ausbildung des Kunststoffgehäuses vorteilhaft. Durch die Füllung mit wärmeleitfähigen Feststoffpartikeln kann eine gute Wärmeleitfähigkeit des Kunststoffgehäuses erreicht werden.

Gemäß einer weiteren bevorzugten Weiterbildung ist vorgesehen, dass der erste, duroplastische Kunststoff mit 5-50%, vorzugsweise 10-30% wärmeleitenden Metallfasern gefüllt ist, und dass die wärmeleitenden Metallfasern aus Kupfer, Aluminium und/oder Silber ausgebildet sind. Somit kann eine notwendige Festigkeit des Kunststoffgehäuses gewährleistet werden.

Gemäß einer weiteren bevorzugten Weiterbildung ist vorgesehen, dass der zweite, elastische Kunststoff aus einem Duroplast oder einem thermoplastischen Elastomer ausgebildet ist. Die Wahl des Materials kann somit an die individuellen Erfordernisse des Kunststoffgehäuses angepasst werden.

Gemäß einer weiteren bevorzugten Weiterbildung ist vorgesehen, dass der zweite, elastische Kunststoff aus Flüssigsilikon ausgebildet ist, und im Gehäuseinneren ausgebildete erste Befestigungsmittel zum Befestigen einer Platine und/oder am Gehäuseäußeren ausgebildete zweite Befestigungsmittel zum Befestigen des Gehäusebauteils an einer Befestigungskomponente mit ausgeformt sind. Das Kunststoffgehäuse sowie die inneren und äußeren Befestigungsmittel können somit in einem einzigen Prozessschritt hergestellt werden.

Die beschriebenen Ausgestaltungen und Weiterbildungen lassen sich beliebig miteinander kombinieren.

Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmale der Erfindung.

### Kurze Beschreibung der Zeichnungen

Die beiliegenden Zeichnungen sollen ein weiteres Verständnis der Ausführungsformen der Erfindung vermitteln. Sie veranschaulichen Ausführungsformen und dienen im Zusammenhang mit der Beschreibung der Erklärung von Prinzipien und Konzepten der Erfindung.

Andere Ausführungsformen und viele der genannten Vorteile ergeben sich im Hinblick auf die Zeichnungen. Die dargestellten Elemente der Zeichnungen sind nicht notwendigerweise maßstabsgetreu zueinander gezeigt.

Es zeigen:
- Fig. 1: eine Schnittansicht eines Spritzgießwerkzeuges einer Spritzgießvorrichtung zur Ausführung einer bevorzugten Ausführungsform der Erfindung;
- Fig. 2: eine Schnittansicht des Spritzgießwerkzeuges der Spritzgießvorrichtung zur Ausführung der bevorzugten Ausführungsform der Erfindung;
- Fig. 3: eine Seitenansicht des Spritzgießwerkzeuges der Spritzgießvorrichtung zur Ausführung der bevorzugten Ausführungsform der Erfindung;
- Fig. 4: eine Schnittansicht eines Kunststoffgehäuses gemäß der bevorzugten Ausführungsform der Erfindung;
- Fig. 5: eine Draufsicht des Kunststoffgehäuses gemäß der bevorzugten Ausführungsform der Erfindung; und
- Fig. 6: ein Ablaufdiagramm eines Verfahrens zum Herstellen des Kunststoffgehäuses mittels einer Spritzgießvorrichtung gemäß der bevorzugten Ausführungsform der Erfindung.

In den Figuren der Zeichnungen bezeichnen gleiche Bezugszeichen gleiche oder funktionsgleiche Elemente, Bauteile oder Komponenten, soweit nichts Gegenteiliges angegeben ist.

Fig. 1 zeigt eine Schnittansicht eines Spritzgießwerkzeuges einer Spritzgießvorrichtung zur Ausführung einer bevorzugten Ausführungsform der Erfindung.

In Fig. 1 ist das Spritzgießwerkzeug 14 gezeigt. Das Spritzgießwerkzeug 14 ist Teil einer (in Fig. 1 nicht gezeigten) Zweikomponenten-Spritzgießvorrichtung. Das Spritzgießwerkzeug 14 ist geeignet, mittels einer ersten Spritzeinheit 12 einen ersten, mit wärmeleitfähigen Kunststoffen modifizierten duroplastischen Kunststoff einzuspritzen. Das Spritzgießwerkzeug 14 ist des Weiteren geeignet, mittels einer zweiten Spritzeinheit 13 einen zweiten, elastischen Kunststoff einzuspritzen.

Die erste Spritzeinheit 12 ist in einem unteren Bereich des Spritzgießwerkzeuges 14 angeordnet, und geeignet, den ersten, duroplastischen Kunststoff in Horizontalrichtung des ersten Spritzgießwerkzeuges 14 einzuspritzen. Die zweite Spritzeinheit 13 ist in einem oberen Bereich des Spritzgießwerkzeuges 14 angeordnet. Die zweite Spritzeinheit 13 ist ausgebildet, mittels zwei im oberen Bereich des Spritzgießwerkzeuges 14 angeordneten Nadelverschlussdüsen 20 den zweiten, elastischen Kunststoff in das Spritzgießwerkzeug 14 einzuspritzen.

Eine jeweilige Nadel der Nadelverschlussdüsen 20 ist in dem in Fig. 1 gezeigten Verfahrensschritt zum Herstellen des Kunststoffgehäuses in einer ersten Position P1 angeordnet, in welcher die jeweilige Nadel derart aus den Nadelverschlussdüsen 20 hervorsteht, dass der zweite, elastische Kunststoff nicht aus der zweiten Spritzeinheit 13 in das Spritzgießwerkzeug 14 austreten kann. Die Nadelverschlussdüsen 20 weisen des Weiteren eine Wasserkühlung 20a auf.

Das Spritzgießwerkzeug 14 weist ferner ein Paar von Formeinsätzen 25 auf, welche mittels einem jeweiligen Kernzug 21 mit Außenwänden des Spritzgießwerkzeuges 14 verbunden sind. Die Formeinsätze 25 sind mittels des jeweiligen Kernzugs 21 in Querrichtung des Spritzgießwerkzeuges 14 von einer geschlossenen in eine offene Position und umgekehrt bewegbar. Das Spritzgießwerkzeug 14, insbesondere ein Gehäuse des Spritzgießwerkzeuges 14 sowie die Formeinsätze 25 des Spritzgießwerkzeuges 14, weisen eine Mehrzahl von elektrischen Heizpatronen 22 auf, welche geeignet sind, das Spritzgießwerkzeug 14 auf eine vorbestimmte Betriebstemperatur zu erwärmen. Das Spritzgießwerkzeug 14 weist des Weiteren in einem oberen, zu den Nadelverschlussdüsen 20 benachbarten Bereich einen Duroplast-Drucksensor 24 auf. Der Duroplast-Drucksensor 24 ist in einem der Formeinsätze integriert. Das Spritzgießwerkzeug 14 weist überdies in einem unteren Bereich einen Auswerfer 26 zum Auswerfen eines hergestellten Gehäusebauteils 10 sowie einen Angusskanal 27 auf, welcher zwischen der ersten Spritzeinheit 12 und den jeweiligen Formeinsätzen 25 des Spritzgießwerkzeuges 14 angeordnet ist.

In einem ersten, in Fig. 1 gezeigten Verfahrensschritt S1 wird ein mit wärmeleitfähigen Füllstoffen modifizierter duroplastischer Kunststoff mit der ersten, horizontalen Spritzeinheit 12 druckgeregelt eingespritzt und das gesamte Gehäusebauteil 10 mit jeweiligen Halterungen bzw. Befestigungen, welche im Gehäuseinneren sowie am Gehäuseäußeren angeordnet sind, ausgeformt. Der Forminnendruck wird dabei von dem Duroplast-Drucksensor 24 an einem Fließwegende überwacht und einer (in Fig. 1 nicht gezeigten) Maschinensteuerung übermittelt. Das Duroplastmaterial ist in der in Fig. 1 gezeigten Ausführungsform durch einen BMC (Bulk Molding Compound) ausgebildet. Alternativ kann das Duroplastmaterial auch durch eine Phenolformmasse oder ein Epoxidharz ausgebildet sein. Das Epoxidharz bzw. die anderen, vorstehend erwähnten verwendbaren Materialien sind mit 50 - 70 % wärmeleitfähigen Feststoffpartikeln, im vorliegenden Ausführungsbeispiel Bornitrid, gefüllt. Alternativ können als Feststoffpartikel auch Aluminiumhydroxid, Magnesiumhydroxid oder eine Kombination aus zumindest einem von Bornitrid, Aluminiuimhydroxid und Magnesiumhydroxid vorgesehen sein.

10 ― 30 % des Duroplastmaterials ist mit wärmeleitenden Metallfasern gefüllt. Die wärmeleitenden Metallfasern sind im vorliegenden Ausführungsbeispiel aus Kupfer ausgebildet. Alternativ können die wärmeleitenden Metallfasern auch aus Aluminium oder Silber, oder einer Kombination aus zumindest einem von Kupfer, Aluminium und Silber ausgebildet sein. Die wärmeleitenden Metallfasern gewährleisten eine notwendige Festigkeit des Gehäusebauteils 10. Trotz des hohen Füllgrads weist der erste, duroplastische Kunststoff in dem mit elektrischen Heizpatronen auf 140°C ― 170°C aufgeheizten Spritzgießwerkzeug 14 eine sehr niedrige Viskosität auf.

Anschließend werden die Nadeln der Nadelverschlussdüsen 20 der auf 30° - 40° gekühlten Nadelverschlussdüsen 20 parallel auf eine zweite Position P2 gezogen, in welcher die Nadeln in die Nadelverschlussdüsen 20 eingefahren sind, sodass der zweite Kunststoff mittels der zweiten Spritzeinheit 13 in das Spritzgießwerkzeug 14 einspritzbar ist. Der erste, duroplastische Kunststoff wird mit der ersten Spritzeinheit 12 der Zweikomponenten-Spritzgießvorrichtung mit einem maximalen Forminnendruck von ca. 200 - 400 bar über den Angusskanal 27 in eine Kavität des Spritzgießwerkzeuges 14 eingespritzt.

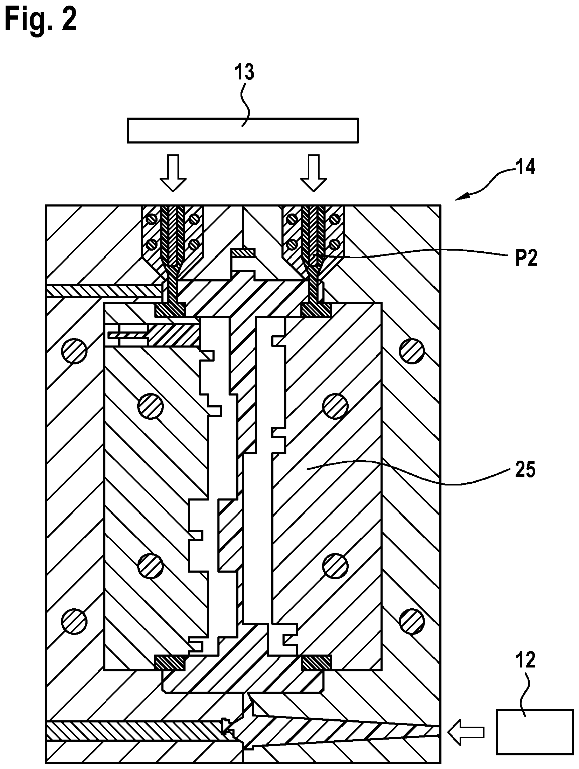

Fig. 2 zeigt eine Schnittansicht des Spritzgießwerkzeuges der Spritzgießvorrichtung zur Ausführung der bevorzugten Ausführungsform der Erfindung.

In Fig. 2 ist das Spritzgießwerkzeug 14 nach dem Einspritzen des zweiten, elastischen Kunststoffes mittels der zweiten Spritzeinheit 13 gezeigt. Nach Abschluss des Einspritzens S1 des ersten, duroplastischen Kunststoffes mittels der ersten Spritzeinheit 12 in das Spritzgießwerkzeug 14 der Zweikomponenten-Spritzgießvorrichtung werden zunächst die hydraulischen Kerne bzw.

Formeinsätze 25 nach einer vorgegebenen Härtezeit des ersten duroplastischen Kunststoffes nach hinten gezogen, und der zweite, elastische Kunststoff mittels der zweiten Spritzeinheit 13 in das Spritzgießwerkzeug 14, insbesondere in eine, in dem Spritzgießwerkzeug 14 ausgebildete Kavität eingespritzt. Der zweite, elastische Kunststoff ist im vorliegenden Ausführungsbeispiel durch Flüssigsilikon ausgebildet. Alternativ kann der zweite Kunststoff auch durch einen anderen geeigneten Duroplast oder einen thermoplastischen Elastomer ausgebildet sein.

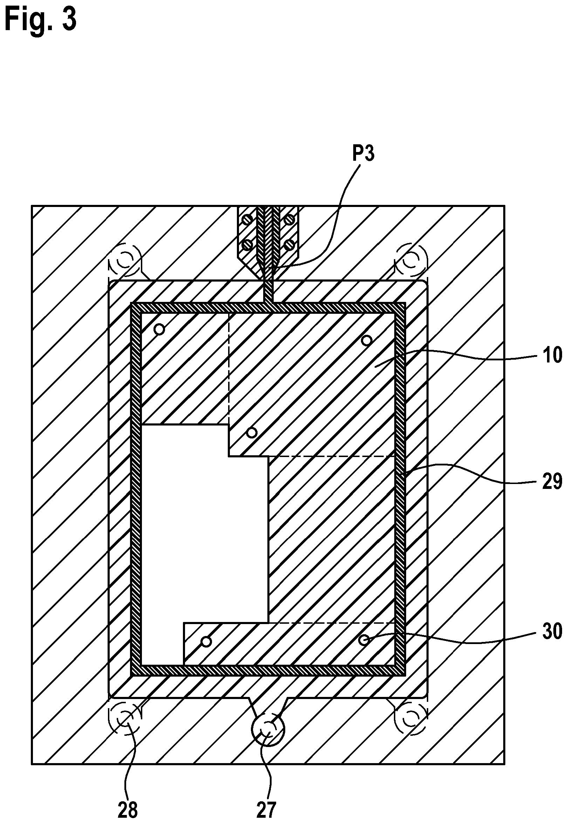

Fig. 3 zeigt eine Seitenansicht des Spritzgießwerkzeuges der Spritzgießvorrichtung zur Ausführung der bevorzugten Ausführungsform der Erfindung.

In der Darstellung von Fig. 3 ist nur einer der Formeinsätze 25 des Spritzgießwerkzeuges 14 gezeigt, so dass eine Seitenansicht auf das in das Spritzgießwerkzeug 14 eingelegte Gehäusebauteil 10 möglich ist. Die Nadeln der Nadelverschlussdüsen 20 sind in einer dritten Position P3 angeordnet. In der dritten Position P3 der Nadeln der Nadelverschlussdüsen 20 sind die Nadeln derart angeordnet, dass diese einen Austritt des zweiten, elastischen Kunststoffes in das Spritzgießwerkzeug 14 verhindern und ein Entformen des Gehäuses aus dem Spritzgießwerkzeug 14 ermöglichen. Mit (in Fig. 3 nicht gezeigten) Auswerfern wird das fertige Gehäusebauteil 10 aus dem Spritzgießwerkzeug 14 geschoben und mit einem (in Fig. 3 nicht gezeigten) Handling entnommen. In Fig. 3 ist in einem äußeren Randbereich des Gehäusebauteils 10 die im vorliegenden Ausführungsbeispiel aus Flüssigsilikon ausgebildete Dichtung 29 gezeigt. Des Weiteren sind die im Gehäuseinneren angeordneten Anschraubpunkte bzw. ersten Befestigungsmittel 30 sowie am Gehäuseäußeren angeordneten zweiten Befestigungsmittel 28 bzw. Trägeranbindung angeordnet. Des Weiteren ist der Angusskanal 27 im unteren Bereich des Gehäusebauteils 10 gezeigt.

Wenn das Gehäuse abgekühlt ist, kann eine bestückte Sensorplatine mit speziellen Duroplastschrauben in die im Gehäuseinneren ausgebildeten ersten Befestigungsmittel 30, welche als Bohrungen ausgebildet sind, verschraubt werden und thermoplastische Abdeckkappen aufgesetzt werden.

Alternativ kann das Gehäusebauteil 10 auch aus einem mit denselben wärmeleitfähigen Füllstoffen verstärkten thermoplastischen Material wie z.B. Polyamid oder Polyphenylensulfid hergestellt werden. Als Dichtungsmaterial kann in einem vergleichbaren Spritzgießwerkzeug beispielsweise bei einer Temperatur von 100°C ― 120°C ein thermoplastisches Elastomer eingespritzt werden.

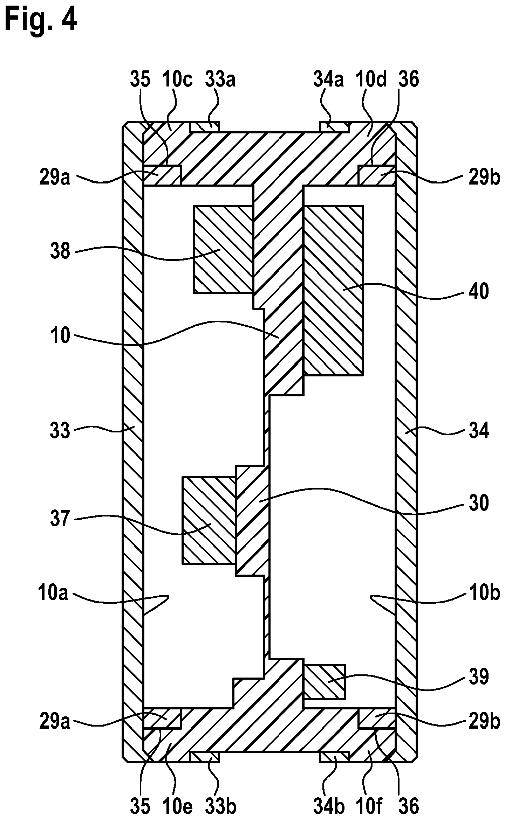

Fig. 4 zeigt eine Schnittansicht eines Kunststoffgehäuses gemäß der bevorzugten Ausführungsform der Erfindung.

Das Kunststoffgehäuse umfasst vorzugsweise ein erstes Dichtungselement 29a, welches mit dem Gehäusebauteil 10 an einem ersten Endabschnitt 10a des Gehäusebauteils 10 stoffschlüssig verbunden ist, und ein zweites Dichtungselement 29b, welches mit dem Gehäusebauteil 10 an einem zweiten Endabschnitt 10b des Gehäusebauteils 10 stoffschlüssig verbunden ist. Alternativ kann das erste Dichtungselement 29a und/oder das zweite Dichtungselement 29b beispielsweise formschlüssig an dem jeweiligen Endabschnitt 10a, 10b des Gehäusebauteils 10 an das Gehäusebauteil 10 angespritzt sein.

Das Kunststoffgehäuse weist vorzugsweise eine erste Abdeckkappe 33 auf, welche an dem ersten Endabschnitt 10a des Gehäusebauteils 10 auf das Gehäusebauteil 10 aufgesetzt ist. Das Kunststoffgehäuse weist vorzugsweise des Weiteren eine zweite Abdeckkappe 34 auf, welche an einem, dem ersten Endabschnitt 10a gegenüberliegenden zweiten Endabschnitt 10b des Gehäusebauteils 10 auf das Gehäusebauteil 10 aufgesetzt ist.

Im Gehäuseinneren des Gehäusebauteils 10 sind die Anschraubpunkte bzw. ersten Befestigungsmittel 30 angeordnet. Vorzugsweise sind auf einer Vorderund Rückseite der ersten Befestigungsmittel 30 Elektronikkomponenten 37, 38, 39 40 angeordnet.

Das Gehäusebauteil 10 weist vorzugsweise an dem ersten Endabschnitt 10a eine erste Übergangsfläche 35 und an dem zweiten Endabschnitt 10b eine zweite Übergangsfläche 35 auf, wobei die erste Übergangsfläche 35 und die zweite Übergangsfläche 36 jeweils benachbart zu einem Randbereich des Gehäusebauteils 10 stufenförmig ausgebildet sind.

Das erste Dichtungselement 29a steht vorzugsweise in Richtung der ersten Abdeckkappe 33 über den ersten Endabschnitt 10a des Gehäusebauteils 10 hervor. Das zweite Dichtungselement 29b steht vorzugsweise in Richtung der zweiten Abdeckkappe 34 über den zweiten Endabschnitt 10b des Gehäusebauteils 10 hervor.

Das erste Dichtungselement 29a dichtet vorzugsweise die erste Übergangsfläche 35 des Gehäusebauteils 10 zu der auf das Gehäusebauteil 10 aufgesetzten ersten Abdeckkappe 33 ab. Das zweite Dichtungselement 29b dichtet vorzugsweise die zweite Übergangsfläche 36 des Gehäusebauteils 10 zu der auf das Gehäusebauteil 10 aufgesetzten zweiten Abdeckkappe 34 ab.

Die erste Abdeckkappe 33 umgreift vorzugsweise das Gehäusebauteil 10 im Bereich des ersten Endabschnitts 10a durch eine mit der ersten Abdeckkappe 33 integral ausgebildete Rastnase 33a, 33b, welche mit einem im Bereich des ersten Endabschnitts 10a des Gehäusebauteils 10 ausgebildeten Vorsprung 10c, 10e im Eingriff ist. Die zweite Abdeckkappe 33 umgreift vorzugsweise das Gehäusebauteil 10 im Bereich des zweiten Endabschnitts 10b durch eine mit der zweiten Abdeckkappe 34 integral ausgebildete Rastnase 34a, 34b, welche mit einem im Bereich des zweiten Endabschnitts 10b des Gehäusebauteils 10 ausgebildeten Vorsprung 10d, 10f im Eingriff ist.

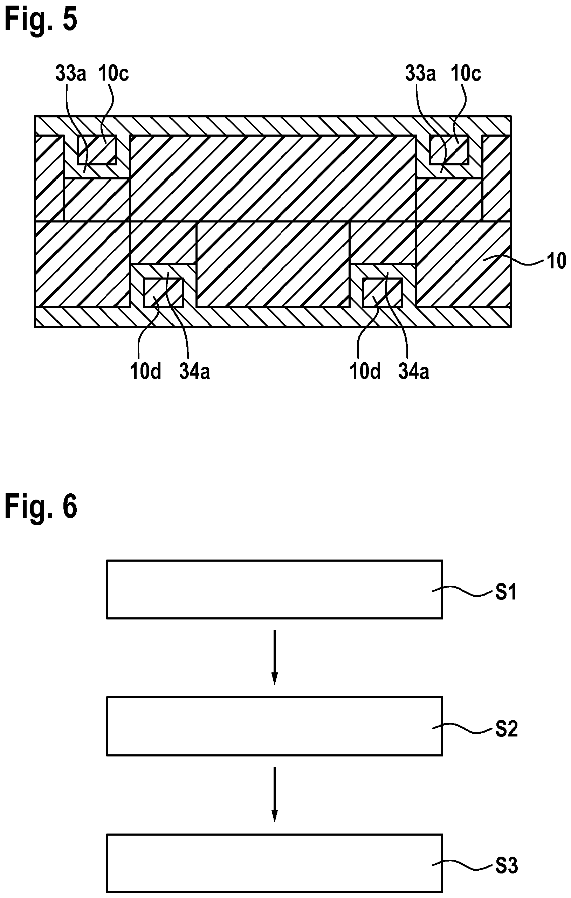

Fig. 5 zeigt eine Draufsicht des Kunststoffgehäuses gemäß der bevorzugten Ausführungsform der Erfindung.

Die mit der ersten Abdeckkappe 33 integral ausgebildete Rastnase 33a ist vorzugsweise rechteckig ausgebildet und weist einen im Wesentlichen mittigen Ausschnitt auf, durch den die Rastnase 33a mit dem im Bereich des ersten Endabschnitts 10a des Gehäusebauteils 10 ausgebildeten Vorsprung 10c, 10e im Eingriff ist. Die mit der zweiten Abdeckkappe 34 integral ausgebildete Rastnase 34a ist vorzugsweise rechteckig ausgebildet und weist einen im Wesentlichen mittigen Ausschnitt auf, durch den die Rastnase 34a mit dem im Bereich des zweiten Endabschnitts 10b des Gehäusebauteils 10 ausgebildeten Vorsprung 10d, 10f im Eingriff ist.

Fig. 6 zeigt ein Ablaufdiagramm eines Verfahrens zum Herstellen des Kunststoffgehäuses mittels einer Spritzgießvorrichtung gemäß der bevorzugten Ausführungsform der Erfindung.

Das Verfahren zum Herstellen eines Kunststoffgehäuses mittels einer Spritzgießvorrichtung umfasst ein Einspritzen S1 eines ersten, mit wärmeleitfähigen Füllstoffen modifizierten duroplastischen oder thermoplastischen Kunststoffes mittels einer ersten Spritzeinheit in eine erste Kavität eines Spritzgießwerkzeuges der Spritzgießvorrichtung zum Ausbilden eines Gehäusebauteils. Das Verfahren umfasst des Weiteren ein Ziehen S2 hydraulischer Kerne in dem Spritzgießwerkzeug zum Ausbilden einer zweiten Kavität in dem Spritzgießwerkzeug. Das Verfahren umfasst überdies ein Einspritzen S3 eines zweiten, elastischen Kunststoffes mittels einer zweiten Spritzeinheit in die in dem Spritzgießwerkzeug ausgebildete zweite Kavität zum Ausbilden eines Dichtungselementes, wobei das Dichtungselement mit dem Gehäusebauteil stoffschlüssig verbunden und/oder an das Gehäusebauteil formschlüssig angespritzt wird. Das Verfahren umfasst darüber hinaus ein Aufsetzen S4 zumindest einer Abdeckkappe an einem Endabschnitt des Gehäusebauteils, wobei das Dichtungselement eine Übergangsfläche des Gehäusebauteils zu der auf das Gehäusebauteil aufgesetzten zumindest einen Abdeckkappe abdichtet.

Obwohl die vorliegende Erfindung anhand bevorzugter Ausführungsbeispiele vorstehend beschrieben wurde, ist sie darauf nicht beschränkt, sondern auf vielfältige Art und Weise modifizierbar. Insbesondere lässt sich die Erfindung in mannigfaltiger Weise verändern oder modifizieren, ohne vom Kern der Erfindung abzuweichen.

Beispielsweise können die wärmeleitfähigen Feststoffpartikel sowie die wärmeleitfähigen Metallfasern, welche jeweils zum Ausbilden des ersten, duroplastischen Kunststoffes befüllt werden, in einem anderen geeigneten Verhältnis zueinander befüllt werden.

## Patentansprüche

1. Kunststoffgehäuse mit:
einem Gehäusebauteil (10), welches aus einem ersten, mit wärmeleitfähigen Füllstoffen modifizierten duroplastischen oder thermoplastischen Kunststoff ausgebildet ist;
zumindest einem Dichtungselement (29a, 29b), welches aus einem zweiten, elastischen Kunststoff ausgebildet ist, wobei das zumindest eine Dichtungselement (29a, 29b) mit dem Gehäusebauteil (10) stoffschlüssig verbunden oder an das Gehäusebauteil (10) formschlüssig angespritzt ist;
zumindest einer Abdeckkappe (33, 34), welche an einem Endabschnitt (10a, 10b) des Gehäusebauteils (10) auf das Gehäusebauteil aufgesetzt ist, wobei das Dichtungselement (29) eine Übergangsfläche (35, 36) des Gehäusebauteils (10) zu der auf das Gehäusebauteil (10) aufgesetzten Abdeckkappe (33, 34) abdichtet,
wobei das Kunststoffgehäuse eine erste Abdeckkappe (33) aufweist, welche an einem ersten Endabschnitt (10a) des Gehäusebauteils (10) auf das Gehäusebauteil (10) aufgesetzt ist, und eine zweite Abdeckkappe (34) aufweist, welche an einem dem ersten Endabschnitt (10a) gegenüberliegenden zweiten Endabschnitt (10b) des Gehäusebauteils (10) auf das Gehäusebauteil (10) aufgesetzt ist,
wobei das Gehäusebauteil (10) an dem ersten Endabschnitt (10a) eine erste Übergangsfläche (35) und an dem zweiten Endabschnitt (10b) eine zweite Übergangsfläche (35) aufweist, wobei die erste Übergangsfläche (35) und die zweite Übergangsfläche (36) jeweils benachbart zu einem Randbereich des Gehäusebauteils (10) stufenförmig ausgebildet sind, und
wobei das Kunststoffgehäuse ein erstes Dichtungselement (29a) aufweist, welches an dem ersten Endabschnitt (10a) des Gehäusebauteils (10) mit dem Gehäusebauteil (10) stoffschlüssig verbunden oder an das Gehäusebauteil (10) formschlüssig angespritzt ist, und ein zweites Dichtungselement (29b) aufweist, welches an dem zweiten Endabschnitt (10b) des Gehäusebauteils (10) mit dem Gehäusebauteil (10) stoffschlüssig verbunden oder an das Gehäusebauteil (10) formschlüssig angespritzt ist.

2. Kunststoffgehäuse nach Anspruch 1, **dadurch gekennzeichnet, dass** das erste Dichtungselement (29a) in Richtung der ersten Abdeckkappe (33) über den ersten Endabschnitt (10a) des Gehäusebauteils (10) hervorsteht und das zweite Dichtungselement (29b) über den zweiten Endabschnitt (10b) in Richtung der zweiten Abdeckkappe (34) des Gehäusebauteils (10) hervorsteht.

3. Kunststoffgehäuse nach einem der vorhergehenden Ansprüche, **dadurch gekennzeichnet, dass** die zumindest eine Abdeckkappe (33, 34) das Gehäusebauteil (10) im Bereich des Endabschnitts (10a, 10b) durch eine mit der Abdeckkappe (33, 34) integral ausgebildete Rastnase (33a, 33b; 34a, 34b) umgreift, welche mit einem im Bereich des Endabschnitts (10a, 10b) des Gehäusebauteils (10) ausgebildeten Vorsprung (10c, 10c; 10d, 10f) im Eingriff ist.

4. Kunststoffgehäuse nach einem der vorhergehenden Ansprüche, **dadurch gekennzeichnet, dass** der erste, duroplastische Kunststoff aus einem Epoxidharz, einer Phenolformmasse oder einem BMC ausgebildet ist, wobei der erste, duroplastische Kunststoff mit 30-90%, vorzugsweise 50-70% wärmeleitfähigen Feststoffpartikeln gefüllt ist, und wobei die wärmeleitfähigen Feststoffpartikel aus Bornitrid, Aluminium- und/oder Magnesiumhydroxid ausgebildet sind.

5. Kunststoffgehäuse nach einem der vorhergehenden Ansprüche, **dadurch gekennzeichnet, dass** der erste, duroplastische Kunststoff mit 5-50%, vorzugsweise 10-30% wärmeleitenden Metallfasern gefüllt ist, und dass die wärmeleitenden Metallfasern aus Kupfer, Aluminium und/oder Silber ausgebildet sind.

6. Kunststoffgehäuse nach einem der vorhergehenden Ansprüche, **dadurch gekennzeichnet, dass** der zweite, elastische Kunststoff aus einem Duroplast oder einem thermoplastischen Elastomer ausgebildet ist.

7. Kunststoffgehäuse nach einem der vorhergehenden Ansprüche, **dadurch gekennzeichnet, dass** der zweite, elastische Kunststoff aus Flüssigsilikon ausgebildet ist, und im Gehäuseinneren ausgebildete erste Befestigungsmittel (30) zum Befestigen einer Platine und/oder am Gehäuseäußeren ausgebildete zweite Befestigungsmittel (28) zum Befestigen des Gehäusebauteils (10) an einer Befestigungskomponente mit ausgeformt sind.

8. Verfahren zum Herstellen eines Kunststoffgehäuses mittels einer Spritzgießvorrichtung, mit den Schritten:
Einspritzen (S1) eines ersten, mit wärmeleitfähigen Füllstoffen modifizierten duroplastischen oder thermoplastischen Kunststoffes mittels einer ersten Spritzeinheit (12) in eine erste Kavität (31) eines Spritzgießwerkzeuges (14) der Spritzgießvorrichtung zum Ausbilden eines Gehäusebauteils (10);
Ziehen (S2) hydraulischer Kerne in dem Spritzgießwerkzeug (14) zum Ausbilden einer zweiten Kavität (32) in dem Spritzgießwerkzeug (14);
Einspritzen (S3) eines zweiten, elastischen Kunststoffes mittels einer zweiten Spritzeinheit (13) in die in dem Spritzgießwerkzeug (14) ausgebildete zweite Kavität (32) zum Ausbilden eines ersten Dichtungselementes (29a), wobei das erste Dichtungselement (29a) an einem ersten Endabschnitt (10a) des Gehäusebauteils (10) mit dem Gehäusebauteil (10) stoffschlüssig verbunden oder an das Gehäusebauteil (10) formschlüssig angespritzt wird und eines zweiten Dichtungselementes (29b), wobei das zweite Dichtungselement (29b) an einem zweiten Endabschnitt (10b) des Gehäusebauteils (10) mit dem Gehäusebauteil (10) stoffschlüssig verbunden oder an das Gehäusebauteil (10) formschlüssig angespritzt wird;
Aufsetzen (S4) einer ersten Abdeckkappe (33) an einem ersten Endabschnitt (10a) des Gehäusebauteils (10) auf das Gehäusebauteil (10) und Aufsetzen einer zweiten Abdeckkappe (34) an einem dem ersten Endabschnitt (10a) gegenüberliegenden zweiten Endabschnitt (10b) des Gehäusebauteils (10) auf das Gehäusebauteil (10), wobei das Dichtungselement (29) eine Übergangsfläche (35, 36) des Gehäusebauteils (10) zu der auf das Gehäusebauteil (10) aufgesetzten zumindest einen Abdeckkappe (33, 34) abdichtet, wobei das Gehäusebauteil (10) an dem ersten Endabschnitt (10a) eine erste Übergangsfläche (35) und an dem zweiten Endabschnitt (10b) eine zweite Übergangsfläche (35) bereitstellt, wobei die erste Übergangsfläche (35) und die zweite Übergangsfläche (36) jeweils benachbart zu einem Randbereich des Gehäusebauteils (10) stufenförmig ausgebildet werden.

## Claims

1. Plastics housing with:
a housing component (10) composed of a first thermoset plastic or thermoplastic respectively modified with thermally conductive fillers;
and with at least one sealing element (29a, 29b) composed of a second, resilient plastic, where the at least one sealing element (29a, 29b) has been cohesively bonded to the housing component (10) or has been moulded in interlocking manner onto the housing component (10);
and with at least one covering cap (33, 34) placed onto the housing component at an end section (10a, 10b) of the housing component (10), where the sealing element (29) seals a transitional area (35, 36) of the housing component (10) in relation to the covering cap (33, 34) placed onto the housing component (10),
where the plastics housing has a first covering cap (33) placed onto the housing component (10) at a first end section (10a) of the housing component (10), and has a second covering cap (30) placed onto the housing component (10) at a second end section (10b) of the housing component (10), said second end section being opposite to the first end section (10a),
where the housing component (10) has a first transitional area (35) at the first end section (10a) and has a second transitional area (35) at the second end section (10b), the first transitional area (35) and the second transitional area (36) respectively being configured in stepped manner and adjacent to a peripheral region of the housing component (10), and
where the plastics housing has a first sealing element (29a) which, at the first end section (10a) of the housing component (10), has been cohesively bonded to the housing component (10) or has been moulded in interlocking manner onto the housing component (10), and where the plastics housing has a second sealing element (29b) which, at the second end section (10b) of the housing component (10), has been cohesively bonded to the housing component (10) or has been moulded in interlocking manner onto the housing component (10).

2. Plastics housing according to Claim 1, **characterized in that**, in the direction of the first covering cap (33), the first sealing element (29a) protrudes beyond the first end section (10a) of the housing component (10) and, in the direction of the second covering cap (34) of the housing component (10), the second sealing element (29b) protrudes beyond the second end section (10b).

3. Plastics housing according to either of the preceding claims, **characterized in that**, in the region of the end section (10a, 10b), the at least one covering cap (33, 34) surrounds the housing component (10) by virtue of a latching lug (33a, 33b; 34a, 34b) which is configured integrally with the covering cap (33, 34) and which engages with a projection (10c, 10c; 10d, 10f) configured in the region of the end section (10a, 10b) of the housing component (10).

4. Plastics housing according to any of the preceding claims, **characterized in that** the first, thermoset plastic is composed of an epoxy resin, a phenolic forming composition or a BMC, where the first, thermoset plastic is filled with 30-90%, preferably 50-70%, of thermally conductive solid particles, and where the thermally conductive solid particles are composed of boron nitride, aluminium hydroxide and/or magnesium hydroxide.

5. Plastics housing according to any of the preceding claims, **characterized in that** the first, thermoset plastic is filled with 5-50%, preferably 10-30%, of thermally conductive metal fibres, and that the thermally conductive metal fibres are composed of copper, aluminium and/or silver.

6. Plastics housing according to any of the preceding claims, **characterized in that** the second, resilient plastic is composed of a thermoset or of a thermoplastic elastomer.

7. Plastics housing according to any of the preceding claims, **characterized in that** the second, resilient plastic is composed of liquid silicone, and configured in the housing interior there are concomitantly moulded first fixing means (30) for the fixing of a circuit board, and/or configured on the housing exterior there are concomitantly moulded second fixing means (28) for the fixing of the housing component (10) on a fixing component.

8. Process for the production of a plastics housing by means of an injection-moulding device, with the steps of:
injection (S1) of a first thermoset plastic or thermoplastic respectively modified with thermally conductive fillers by means of a first injection unit (12) into a first cavity (31) of an injection mould (14) of the injection-moulding device in order to configure a housing component (10);
withdrawal (S2) of hydraulic cores in the injection mould (14) in order to configure a second cavity (32) in the injection mould (14);
injection (S3) of a second, resilient plastic by means of a second injection unit (13) into the second cavity (32) configured in the injection mould (14) in order to configure a first sealing element (29a), where, at a first end section (10a) of the housing component (10), the first sealing element (29a) is cohesively bonded to the housing component (10) or is moulded in interlocking manner onto the housing component (10), and in order to configure a second sealing element (29b), where, at a second end section (10b) of the housing component (10), the second sealing element (29b) is bonded cohesively to the housing component (10) or is moulded in interlocking manner onto the housing component (10);
placement (S4) of a first covering cap (33) onto the housing component (10) at a first end section (10a) of the housing component (10) and placement of a second covering cap (34) onto the housing component (10) at a second end section (10b) of the housing component (10), said second end section being opposite to the first end section (10a), where the sealing element (29) seals a transitional area (35, 36) of the housing component (10) in relation to the at least one covering cap (33, 34) placed onto the housing component (10), where the housing component (10) provides a first transitional area (35) at the first end section (10a) and provides a second transitional area (35) at the second end section (10b), where the first transitional area (35) and the second transitional area (36) respectively are configured in stepped manner and adjacent to a peripheral region of the housing component (10).

## Revendications

1. Boîtier en matière plastique comprenant :
un composant de boîtier (10), qui est formé par une première matière plastique thermodurcissable ou thermoplastique modifiée par des charges aptes à conduire la chaleur,
au moins un élément d'étanchéité (29a, 29b), qui est formé par une deuxième matière plastique élastique, l'au moins un élément d'étanchéité (29a, 29b) étant relié au composant de boîtier (10) par accouplement de matière ou moulé par injection sur le composant de boîtier (10) par accouplement de forme ;
au moins un couvercle (33, 34), qui est placé sur le composant de boîtier au niveau d'une section d'extrémité (10a, 10b) du composant de boîtier (10), l'élément d'étanchéité (29) étanchéifiant une surface de transition (35, 36) du composant de boîtier (10) vis-à-vis du couvercle (33, 34) placé sur le composant de boîtier (10),
le boîtier en matière plastique comprenant un premier couvercle (33), qui est placé sur le composant de boîtier (10) au niveau d'une première section d'extrémité (10a) du composant de boîtier (10), et un deuxième couvercle (34), qui est placé sur le composant de boîtier (10) au niveau d'une deuxième section d'extrémité (10b) du composant de boîtier (10) opposée à la première section d'extrémité (10a),
le composant de boîtier (10) comprenant une première surface de transition (35) au niveau de la première section d'extrémité (10a) et une deuxième surface de transition (35) au niveau de la deuxième section d'extrémité (10b), la première surface de transition (35) et la deuxième surface de transition (36) étant chacune configurées sous forme échelonnée à côté d'une zone de bord du composant de boîtier (10), et
le boîtier en matière plastique comprenant un premier élément d'étanchéité (29a), qui est relié au composant de boîtier (10) par accouplement de matière au niveau de la première section d'extrémité (10a) du composant de boîtier (10) ou moulé par injection sur le composant de boîtier (10) par accouplement de forme, et un deuxième élément d'étanchéité (29b), qui est relié au composant de boîtier (10) par accouplement de matière au niveau de la deuxième section d'extrémité (10b) du composant de boîtier (10) ou moulé par injection sur le composant de boîtier (10) par accouplement de forme.

2. Boîtier en matière plastique selon la revendication 1, **caractérisé en ce que** le premier élément d'étanchéité (29a) dépasse au-dessus de la première section d'extrémité (10a) du composant de boîtier (10) en direction du premier couvercle (33) et le deuxième élément d'étanchéité (29b) dépasse au-dessus de la deuxième section d'extrémité (10b) en direction du deuxième couvercle (34) du composant de boîtier (10).

3. Boîtier en matière plastique selon l'une quelconque des revendications précédentes, **caractérisé en ce que** l'au moins un couvercle (33, 34) vient en prise autour du composant de boîtier (10) dans la zone de la section d'extrémité (10a, 10b) par un bec d'encliquetage (33a, 33b ; 34a, 34b) formé d'un seul tenant avec le couvercle (33, 34), qui est en prise avec une protubérance (10c, 10c ; 10d, 10f) formée dans la zone de la section d'extrémité (10a, 10b) du composant de boîtier (10).

4. Boîtier en matière plastique selon l'une quelconque des revendications précédentes, **caractérisé en ce que** la première matière plastique thermodurcissable est formée par une résine époxyde, un matériau de moulage phénol ou un BMC, la première matière plastique thermodurcissable étant chargée avec 30 à 90 %, de préférence 50 à 70 %, de particules solides aptes à conduire la chaleur, et les particules solides aptes à conduire la chaleur étant formées par du nitrure de bore, de l'hydroxyde d'aluminium et/ou de magnésium.

5. Boîtier en matière plastique selon l'une quelconque des revendications précédentes, **caractérisé en ce que** la première matière plastique thermodurcissable est chargée avec 5 à 50 %, de préférence 10 à 30 %, de fibres métalliques conduisant la chaleur, et **en ce que** les fibres métalliques conduisant la chaleur sont formées par du cuivre, de l'aluminium et/ou de l'argent.

6. Boîtier en matière plastique selon l'une quelconque des revendications précédentes, **caractérisé en ce que** la deuxième matière plastique élastique est formée par un thermodurcissable ou un élastomère thermoplastique.

7. Boîtier en matière plastique selon l'une quelconque des revendications précédentes, **caractérisé en ce que** la deuxième matière plastique élastique est formée par de la silicone liquide, et des premiers moyens de fixation (30) formés à l'intérieur du boîtier pour la fixation d'une platine et/ou des deuxièmes moyens de fixation (28) formés à l'extérieur du boîtier pour la fixation du composant de boîtier (10) à une pièce de fixation sont formés avec celle-ci.

8. Procédé de fabrication d'un boîtier en matière plastique au moyen d'un dispositif de moulage par injection, comprenant les étapes suivantes :
l'injection (S1) d'une première matière plastique thermodurcissable ou thermoplastique modifiée par des charges aptes à conduire la chaleur au moyen d'une première unité d'injection (12) dans une première cavité (31) d'un outil de moulage par injection (14) du dispositif de moulage par injection pour la formation d'un composant de boîtier (10) ;
l'étirage (S2) de noyaux hydrauliques dans l'outil de moulage par injection (14) pour la formation d'une deuxième cavité (32) dans l'outil de moulage par injection (14) ;
l'injection (S3) d'une deuxième matière plastique élastique au moyen d'une deuxième unité d'injection (13) dans la deuxième cavité (32) formée dans l'outil de moulage par injection (14) pour la formation d'un premier élément d'étanchéité (29a), le premier élément d'étanchéité (29a) étant relié au composant de boîtier (10) par accouplement de matière au niveau d'une première section d'extrémité (10a) du composant de boîtier (10) ou étant moulé par injection sur le composant de boîtier (10) par accouplement de forme, et d'un deuxième élément d'étanchéité (29b), le deuxième élément d'étanchéité (29b) étant relié au composant de boîtier (10) par accouplement de matière au niveau d'une deuxième section d'extrémité (10b) du composant de boîtier (10) ou étant moulé par injection sur le composant de boîtier (10) par accouplement de forme ;
la mise en place (S4) d'un premier couvercle (33) sur le composant de boîtier (10) au niveau d'une première section d'extrémité (10a) du composant de boîtier (10) et la mise en place d'un deuxième couvercle (34) sur le composant de boîtier (10) au niveau d'une deuxième section d'extrémité (10b) du composant de boîtier (10) opposée à la première section d'extrémité (10a), l'élément d'étanchéité (29) étanchéifiant une surface de transition (35, 36) du composant de boîtier (10) vis-à-vis de l'au moins un couvercle (33, 34) placé sur le composant de boîtier (10), le boîtier en matière plastique (10) comprenant une première surface de transition (35) au niveau de la première section d'extrémité (10a) et une deuxième surface de transition (35) au niveau de la deuxième section d'extrémité (10b), la première surface de transition (35) et la deuxième surface de transition (36) étant chacune configurées sous forme échelonnée à côté d'une zone de bord du composant de boîtier (10).
